# EUROPEAN PATENT SPECIFICATION

(11) **EP 4 161 224 B1**
(45) Date of publication and mention of the grant of the patent: **04.03.2026**
(21) Application number: 21200765.2
(22) Date of filing: 04.10.2021
(51) Int. Cl.: H05K 3/00, H05K 1/11, H05K 1/18, H05K 3/46, H05K 3/42

(54) **PARTIALLY FILLING A COMPONENT CARRIER OPENING IN A CONTROLLED MANNER**
KONTROLLIERTE TEILBEFÜLLUNG EINER KOMPONENTENTRÄGERÖFFNUNG
REMPLISSAGE PARTIEL D'UNE OUVERTURE DE SUPPORT DE COMPOSANTS DE MANIÈRE CONTRÔLÉE

(43) Date of publication of application: 05.04.2023
(73) Proprietor: AT & S Austria Technologie & Systemtechnik Aktiengesellschaft, 8700 Leoben (AT)
(72) Inventor: Wulz, Thomas, 8700 Leoben (AT); Schlick, Daniel, 8733 St. Marein-Feistritz (AT); Lackner, Sebastian, 8773 Kammern i. L. (AT); Wilding, Dominik, 8720 Knitteldelf (AT)
(74) Representative: Dilg, Haeusler, Schindelmann Patentanwaltsgesellschaft mbH

(56) References cited:
- US-A- 6 015 520
- US-A1- 2017 066 868

## Description

### Field of the Invention

The invention relates to a component carrier with an opening and a curable dielectric element. The invention further relates to a component carrier arrangement that includes the component carrier. Further, the invention relates to a method of manufacturing the component carrier. Furthermore, the invention relates to a specific uses.

Accordingly, the invention may relate to the technical field of component carriers such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, partially (not fully) filling a component carrier opening such as a through hole or a cavity may be considered a challenge. For example, a lamination step with resin would completely fill component carrier opening. Further, the interconnection of component carriers (for example plug-in connection) may still be considered a cumbersome task.

Conventionally, the partial filling of circuit board holes may be done by non-conductive paste (plugin paste) to form partly opened holes (e.g. for a plug-in/press-fit insertion). However, these processes may not be reliable and robust during component carrier manufacturing. In particular, it may not be feasible to control the resin filling depth and the resin filling amount of the openings. Additionally, the mechanical stability of non-conductive paste may not be enough to stop further resin from flowing into the opening during a subsequent lamination step. However, a low-quality partial hole filling may result in a malfunctioning circuit board and/or a poor circuit board interconnection.

US 6 015 520 A discloses a method for filling holes such as plated through holes (PTH) in a printed wiring board. A photoimageable material (PIM) is applied on the printed circuit board and an amount of PIM sags or seeps into the PTH. The PIM is subsequently exposed to UV light in the region of the PTH.

### Summary of the Invention

There may be a need to fill a component carrier opening to a specific height in a reliable and robust manner.

A component carrier, a component carrier arrangement, a method of manufacturing, and a use of the method according to the independent claims are provided.

According to an aspect of the invention, there is described a component carrier according to claim 1.

According to a further aspect of the invention, there is described a component carrier arrangement according to claim 10.

According to a further aspect of the invention, there is described a method of manufacturing a component carrier according to claim 11.

According to a further aspect of the invention, there is described a use (method of using) the method described above for interconnecting the component carrier with a further component carrier and/or a further component (and forming a component carrier arrangement) at the opening.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a (layer) stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

The term "layer structure" may particularly denote a continuous layer, a patterned layer or a plurality of non-consecutive islands within a common plane.

In the context of the present document, the term "curable dielectric element" may refer to any electrically insulating material that is curable, i.e. the material can be in an uncured state, and later in time, in a cured state, wherein the cured state is more cured (hardened) than the uncured state. In other words, a cure state criterion such as the state of cross-linking and/or the viscosity changes from the uncured state to the cured state.

For example, the dielectric material may be a non-enforced resin or a prepreg. Such materials are applied in component carrier manufacturing generally in an uncured state and will cure over time (depending on the material, the curing may take hours, days, weeks or months). In the uncured state, the dielectric material may be able to flow. In a pre-cured state, the dieletric material may be partially able to flow. In contrast to this, a so-called core layer normally comprises fully cured material in order to serve for mechanical stabilization. There are different methods that allow to determine the cure state of a curable dielectric element. In an example, the cure state is predetermined to allow a specific flow amount and/or a specific flow speed. An applied dielectric material may thus be tuned (for example by waiting for a specific time, using temperature curing (elevated temperatures), or hardening with UV light) in order to achieve the desired cure state based on a cure state criterion. In an example, curing may be done by a (any) electromagnetic radiation, e.g. with a wavelength 0.1 to 3000 nm, in particular 10 to 2000 nm, more in particular 100 to 1000 nm. Curing may be also done using a heat source, whereby a source of electromagnetic radiation may also be seen as a heat source in this context. In the context of the present document, the term "opening" may particularly denote any aperture in the layer stack of a component carrier, in particular in an electrically insulating layer structure. In an example, the opening is a (plated) through-hole that should be partially filled from only one direction, to enable a press-fit connection from the other (opposed) direction. In a specific example, there is a plurality of through holes that form an array. In another example, the opening is a blind hole that should be filled only partially (to a predetermined depth). In a further example, the opening is a (fluid-filled) cavity, in particular embedded in component carrier material. An electronic component such as an IC may be placed into such a cavity and the curable material may be used to only partially embed the component (e.g. only the sidewalls).

In the context of the present document, the term "interface pattern" may particularly denote any pattern that may be determined at an interface between a first curable dielectric element and a second curable dielectric element. These elements have different cure states during manufacturing which may result in said interface pattern. Further, a part of the second curable dielectric element may be cut-out and/or the first curable dielectric element may be cut to a specific shape before arranging. These processes may also result in the interface pattern. In a specific example, the interface pattern may comprise at least one glass fiber that has been cut. Further patterns may include alignment shifts, smearing, tapering, or color change.

In an illustrative example, not forming part of the invention, there is one curable dielectric element applied (e.g. laminated) and (pre-) treated at preferred or desired positions to tune the dielectric layer towards specific physical properties e.g. viscosity, hardness. These tuned positions may be considered as the first curable dielectric element, while the not-tuned positions may be considered as the second curable dielectric element. In this illustrative example, example, there may be no abrupt interface between the first and second curable dielectric element. The interface patterns may be for example caused by the heat transfer inside the (polymeric) dielectric material.

According to an exemplary embodiment, the invention may be based on the idea that a component carrier opening can be filled to a desired filling height (e.g. completely filled, partially filled) in a reliable and robust manner, when a first (pre-cured) curable dielectric element is arranged on the opening, adjacent to a second (not pre-cured) curable dielectric element. The first curable dielectric element may be tuned/pre-cured to reach a specific predetermined cure state (cure state criterion), so that a flow of first curable dielectric material (from the first curable dielectric element) into the opening can be controlled. In particular, the amount of flowing material and the speed of flowing material may be controllable, when applying a specific pre-determined cure state, so that a precise filling depth of the opening may be achieved. Further, e.g. due to surface tension, applied pressure and friction at the side walls, a curved shape (with angles, e.g. concave or convex) of the curable material in the opening may be achieved. In an example, a second curable dielectric material, such as prepreg, may be analyzed prior to a lamination (pressing) step, in order to check the viscosity (cure state). Based on the results, a customized pre-curing parameter (cure state criterion) may be fixed. Defined areas of the second curable dielectric element may be cut-out and replaced by the pre-cured first curable dielectric element. This pre-cured first curable dielectric element may provide a controlled (resin) flow into the opening. The precisely partially filled opening (which may be further laminated at the filled opening side) may be used for a plug-in connection that allows a reliable connection between two component carriers.

As can be seen from this example, the described process may even provide two different advantages: i) a component carrier opening may be partially filled in a controlled manner, and ii) two component carrier may be interconnected in a robust manner.

### Exemplary Embodiments

According to an embodiment, the cure state (determined for example by the state of cross-linking or the viscosity) of the first dielectric element may be more cured than the cure state of the second dielectric element during component carrier manufacturing. This difference in the cure state is determinable at the interface region as an interface pattern (for example a cut glass fiber when a prepreg is used).

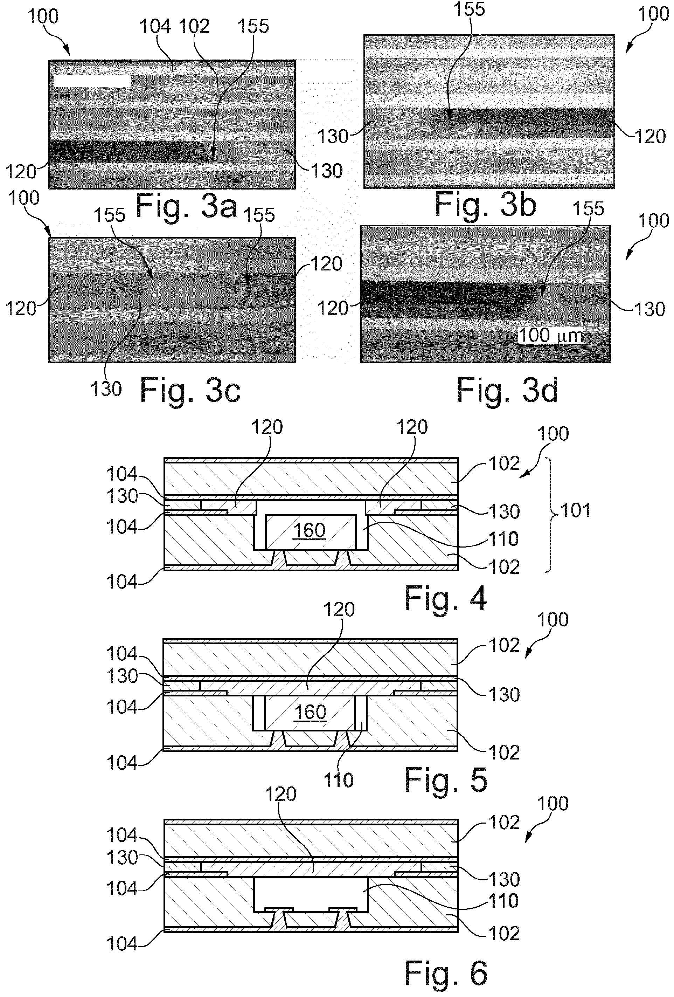

According to a further embodiment, the interface pattern comprises at least one of the group which consists of a cut fiber (in particular glass fiber or carbon fiber), an alignment shift, a smearing, a colour shift, a tapering. The above described difference in the cured state may be directly reflected as one of the above identified patterns (see also Figures 3a to 3d).

In an example, the first curable dielectric element is cut to a specific shape to fit between second curable dielectric element(s). In a further example, a part of the second curable dielectric element is cut out in order to provide a space for the first curable dielectric element. In the case that a fiber-enforced resin (a prepreg) is applied, both examples would lead to a specific cut pattern of said fibers.

According to the invention, a part of the first curable dielectric element extends (partially) into the opening. This may provide the advantage that the extending part fills only a part of the opening in a controlled manner. While a dielectric element in a second (uncured) cure state would somehow fill the opening in an uncontrollable manner, a dielectric element with a (predetermined) first cure state would, in contrast, partially expand into the opening in a desired manner. In an example, the part of the first curable dielectric element fills around half of the opening. In another example, the part of the first curable dielectric element fills around one quarter or around three quarters of the opening.

In an embodiment, the opening comprises a larger diameter at the top (wherein the part of the first curable element extends into), so that curable material (polymer) is able to flow into the opening in controlled manner.

According to a further embodiment, the part of the first curable dielectric element extends into the opening to a specific filling height (depth). In an example, the filling height corresponds to 2% or more (in particular 5% or more, 10% or more, 20% or more, 30%, 40% or more) of the opening volume. In a further example, the filling height corresponds to 90% or less (in particular 80% or less, 70% or less, 60% or less, 50% or less) of the opening volume. Thus, a specific filling height, depending on the desired application, may be efficiently achieved.

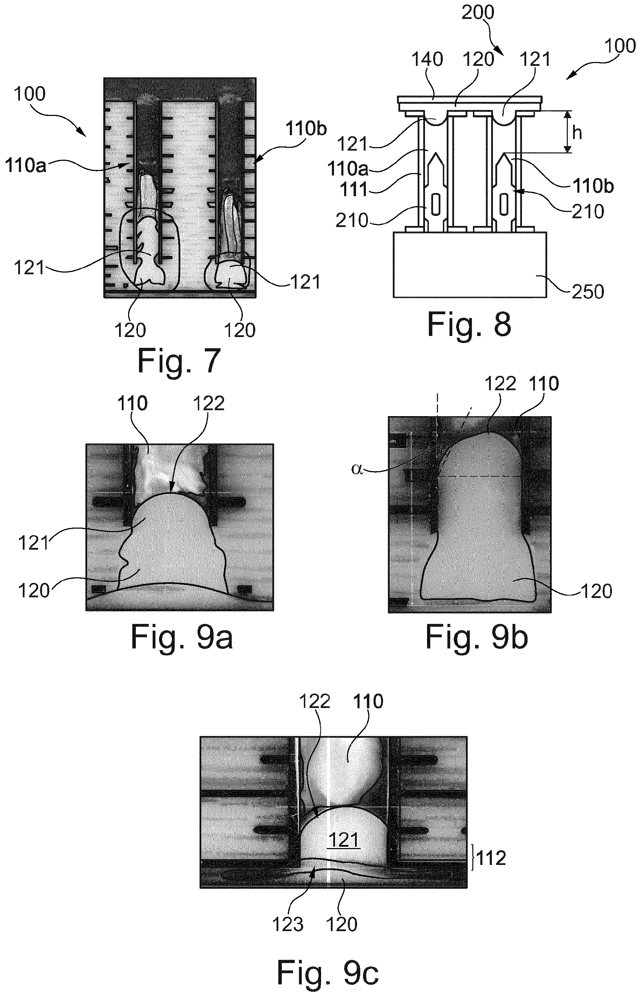

According to a further embodiment, the part of the first curable dielectric element, that extends into the opening, comprises a shaped main surface, in particular a hemisphere-like shape, more in particular a concave or convex shape. Depending on the application, such a specific shape may be advantageous. The shape, in particular concave/convex, may be further described by an angle between the opening sidewall and the curvature of the main surface of the extending part (see also Figure 9b).

In this context, the term "main surface" may denote the surface of the portion of the curable dielectric element that is extended most into the opening. For example, the curable dielectric element may comprise the shape of a droplet, then the main surface may be curved in a convex manner. The main surface of the curable dielectric element should not be confused with a component carrier main surface (which may be oriented in parallel with the direction of main extension of the component carrier).

In this context, the term "top of the opening" may refer to the outermost part of the opening, wherein said "top" may be in direct contact with a component carrier layer structure main surface.

According to a further embodiment, (at least one of) the part(s) of the first curable dielectric element, that extends into the opening, (essentially) comprises no glass-fibers. In particular, wherein a glass fiber of the first curable dielectric element forms a wave-like structure at the opening main surface. The glass-fiber may be partially sucked into the opening, so that the wave-like shape is obtained. In some cases, a part of a (broken) glass fiber may be found in the extending part.

According to a further embodiment, the opening comprises at least one of the group which consists of a blind hole, a through hole, a cavity, a trench, a recess between (metal) traces. This may provide the advantage that the described process can be applied for a plurality of different designs.

Partially filling a through hole may provide the particular advantage that a further build-up process (lamination) on the first curable dielectric element is enabled without completely filling the through hole by the lamination step.

Partially filling a cavity may for example provide the specific advantage that a component in the cavity may be encapsulated in a specific manner, e.g. only at the sidewalls.

According to a further embodiment, sidewalls of the opening are at least partially covered by an electrically conductive material (e.g. plated through holes). This may provide the advantage that an electrical connection with a protruding element of a further component carrier (in case of a plug-in connection) may be established.

According to a further embodiment, the second curable dielectric element is not arranged on (top of) the opening. This measure may advantageously prevent that uncured dielectric material flows in an uncontrolled manner into the opening.

According to a further embodiment, a diameter of the opening exposed at a layer stack main surface (opening main surface) (in particular an electrically insulating layer structure main surface) is larger than a diameter of the opening which is not exposed at the layer stack main surface (an opening diameter at the top of the opening is larger than a non-opening diameter of the opening). In other words, a part of the opening (in particular hole) may be enlarged towards a layer stack main surface. This measure may allow material of the first curable dielectric element to flow efficiently into the opening.

According to a further embodiment, the diameter at the opening main surface is a backdrill-opening manufactured by a back-drill process. An opening with a broader opening diameter may be advantageous for signal transmission (the opening sidewalls may be used for this purpose), in particular for HF applications.

According to a further embodiment, the first curable dielectric element and/or the second curable dielectric element is configured as a layer structure, in particular a sheet. Thereby, the element(s) can be arranged/placed on the opening (and or a main surface of the layer stack/electrically insulating layer structure) in a robust manner. By applying a layer structure (such as a sheet) instead of paste, even a plurality of openings (such as an array of through holes) may be efficiently filled only partially in a controlled manner.

According to a further embodiment, the first curable dielectric element and the second curable dielectric element comprise the same material or consist of the same material, in particular wherein said material only differs in the cure state. This may provide the advantages that the manufacturing process is implemented straightforward and that a misfit (for example regarding the thermal extension) of the dielectric elements may be avoided.

According to a further embodiment, the first curable dielectric element and/or the second curable dielectric element comprises at least one of the group which consists of a (non-enforced) resin, a prepreg, an epoxy resin, an Ajinomoto Build-up Film (ABF), polyimide (PI), Teflon, PVDF, a polyamine, a polyester, in particular cyanate ester resin, a benzocyclobutene resin, a bismaleimide-triazine resin, a polyphenylene derivate, a polyphenylene ether, in particular Megtron 7. In this manner, established and standardized industry material may be directly applied. Further examples of curable dielectric materials are listed further below.

According to a further embodiment, the opening is a fluid-filled, in particular gas (in particular air) filled, cavity embedded in the layer stack (see e.g. Figure 6). For example, the cavity may be formed in an electrically insulating layer structure of the layer stack. The cavity may be exposed or may be covered by further layer structures of the layer stack. The first curable dielectric element may serve for partially filling the cavity in a specific manner. An advantage of the gas-filling may be seen in that unwanted surface oxidation is reduced.

According to a further embodiment, the opening is a cavity embedded in the layer stack, and the component carrier further comprises a component, in particular an electric or electronic component, embedded in the cavity.

According to a further embodiment, the component is at least partially covered by the first curable dielectric element (see e.g. Figure 5). In this example, the first curable dielectric element may be arranged on a main surface of the layer(s) in which the cavity is formed. Thereby, a region between sidewalls of the component and sidewalls of the cavity may be filled in a controlled manner (partial component encapsulation).

According to a further embodiment, the component is not covered by the first curable dielectric element (see e.g. Figure 4). This may be advantageous, when only sidewalls of the component should be encapsulated and the upper main surface should be exposed.

According to a further embodiment, the top of a sidewall of the cavity is at least partially covered by the first curable dielectric element. According to a further embodiment, the top of the sidewall of the cavity is not covered by the first curable dielectric element.

According to a further embodiment, the connection of the arrangement is a plug-in connection, in particular a press-fit connection (see Figure 7). The further component (carrier) may comprise a protruding element (e.g. an electrically conductive or electrically insulating element) (for example formed as a bolt) that can be plugged/pressed into the partially filled opening. Thereby, the extending part may only extend to a specific filling height.

In an embodiment, there are provided a plurality of through holes at the component carrier and a plurality of protruding elements at the further component (carrier), so that a robust interconnection is enabled. In an example, the stacking direction is along the Z-direction (perpendicular to the directions of main extension of the component carriers). In another example, one component carrier is attached to the sidewall of the other component carrier.

According to a further embodiment, the arrangement comprises at least three (in particular at least four, more in particular at least five, more in particular at least ten) component carriers. This may provide the advantage that a large layer stack can be provided in a reliable and robust manner (while the number of lamination steps is reduced).

According to a further embodiment, the first curable dielectric element extends partially into the opening (see above).

According to a further embodiment of the method, extending comprises: flowing material of the first curable dielectric element into the opening in a controlled manner, in particular with respect to at least one of the group which consists of the filling depth, the amount of flow material, the speed of flow material, a shape of the flow material. In this manner, a desired partial filling may be accurately adjusted.

According to a further embodiment, the method further comprises: arranging the second curable dielectric element partially on the opening, removing a part of the second curable dielectric element to provide a cut-out region on the opening, and arranging the first curable dielectric element in the cut-out region (the other way around may also be possible). This measure enables a (design) flexible application of the first curable dielectric element.

According to a further embodiment, the method further comprises arranging a curable dielectric element at least partially on the opening, and tuning (applying specific methods/parameters) the cure state of a portion of the curable dielectric element, thereby forming the first dielectric element (the tuned portion) being adjacent to the second dielectric element (the un-tuned portion). In this manner, the first and the second curable dielectric element may be manufactured from one and the same curable dielectric element (layer).

According to a further embodiment, the first cure state comprises a cross-linking of dielectric material (cure state criterion) in the range 10 to 50%, in particular 20 to 40, in particular 25 to 35.

According to a further embodiment, the first cure state comprises a viscosity in the range 10⁻⁴ to 10⁸ Pa*s, in particular 10² - 10⁷ Pa*s. The viscosity may be highly dependent on the temperature, the shear rate, and the composition of the material (polymer, additives etc.) In a specific embodiment, the following parameters have been applied: frequency: 10 rad/s = 1,59 Hz, strain amplitude: 0,01%, temperature range: 100°C -200°C.

According to a further embodiment, the method further comprises analyzing the cure state of the first curable dielectric element and/or the second curable dielectric element to determine the first cure state and/or the second cure state.

According to a further embodiment, the method further comprises: i) predefining a cure state criterion, and ii) tuning/adapting the first curable dielectric element so that the first cure state fulfills the cure state criterion. As stated above, the cure state criterion may for example refer to the viscosity, the state of cross-linking, or the hardness. After determining the cure state criterion of the curable dielectric element, it may be checked if this cure state already fulfills the predetermined cure state criterion. If so, the curable dielectric element may be directly applied. If not, the cure state may be adapted to the predetermined cure state criterion (in particular including at least one of viscosity, filling height, flow speed, etc.). Examples for this tuning may include: waiting for a specific time, applying electromagnetic radiation (in particular UV radiation), baking in an oven with a defined temperature and specific parameters, e.g. including time, pressure, chemical interaction.

According to a further embodiment, the method further comprises laminating a further electrically insulating layer structure and/or a further electrically conductive layer structure on (top of) the first curable dielectric element (in particular wherein the first cure state and the second cure state are different after lamination or wherein the first cure state and the second cure state are the same after lamination). This may provide the advantage that a further layer build-up on the layer stack can be performed without (completely) filling the opening(s). Thus, an especially efficient and robust component carrier manufacturing may be provided.

According to a further embodiment, the method further comprises: separating at least a part of the first curable dielectric element and the second curable dielectric element by laser cutting. This process may be detectable (e.g. using an electron microscope) by a carbonization at the interface.

According to a further embodiment, the method further comprises: back-drilling the opening at an opening main surface that is exposed to a layer stack main surface. This measure may improve signal transmission quality (at the opening sidewalls).

According to an embodiment, a controllable epoxy flow into a defined opening is provided to prevent complete filling. This flow control is enabled through different curing stages of the epoxy in different areas of the layer. The method enables through hole component assembly and can be used for Z-interconnection products, standard PCB, and PCB with through hole assembly.

According to an embodiment, at least one part of the first curable dielectric element, that extends into the opening, does (essentially) not comprises glass fibers (even though other parts of the first curable material may comprise glass fibers). In an example, there are no glass fibers found at the interface between the dielectric material and (the gas in) the opening. In some cases, the glass fibers are sucked a little into the opening, which may create a wavelike structure (see Figure 9c). Therefore, the opening is mostly filled with polymer, even if reinforcement glass fibers are included in the resin material.In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a side view of a component carrier according to an exemplary embodiment of the invention.
Figures 2a to 2d show a method of manufacturing a component carrier according to an exemplary embodiment of the invention.
Figures 3a to 3d respectively show an interface pattern according to exemplary embodiments of the invention.
Figure 4 shows a side view of a component carrier with a component in a cavity according to an illustrative example not belonging to the invention.
Figure 5 shows a side view of a component carrier with a component in a cavity according to another illustrative example not belonging to the invention.
Figure 6 shows a side view of a component carrier with a fluid-filled cavity according to an illustrative example not belonging to the invention.
Figure 7 shows a side view of two different filling heights in the opening according to an exemplary embodiment of the invention.
Figure 8 shows a component carrier arrangement according to an exemplary embodiment of the invention.
Figures 9a to 9c show side views of a specifically shaped part of the first curable dielectric element in the opening, respectively, according to exemplary embodiments of the invention.

### Detailed Description of the Drawings

The illustrations in the drawings are schematic. In different drawings, similar or identical elements are provided with the same reference signs.

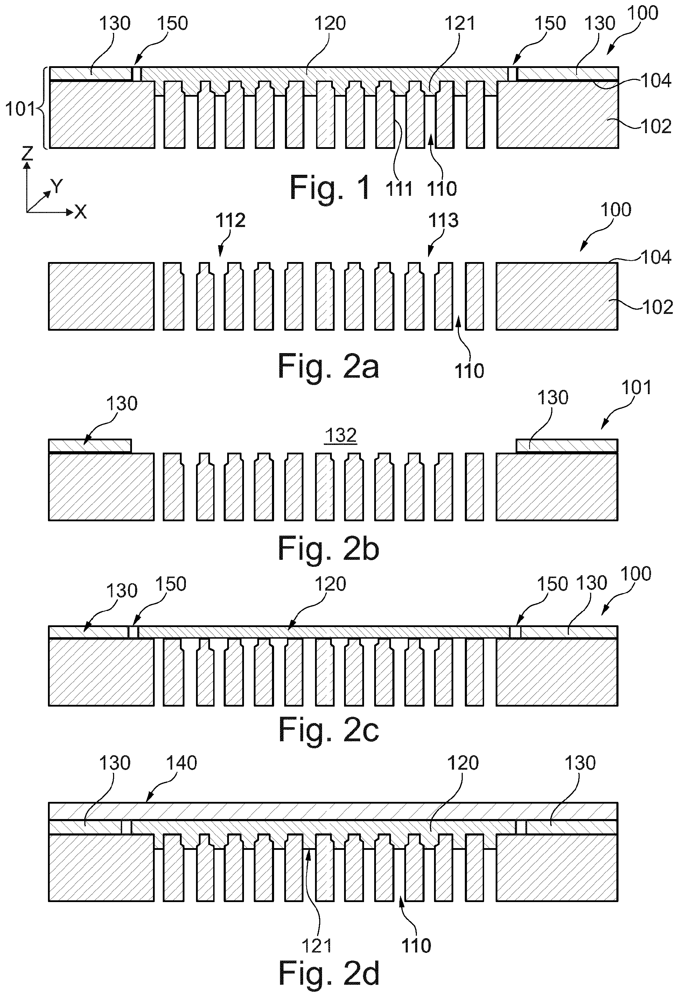

**Figure 1** shows a side view of a component carrier 100 according to an exemplary embodiment of the invention. The component carrier 100 comprises a layer stack 101 with an electrically insulating layer structure 102 (for example a core layer) and thin electrically conductive layer structures 104 that sandwich the electrically insulating layer structure 102. A plurality of openings 110 in the form of through holes are formed in the layer stack 101 and through the electrically insulating layer structure 102. The through holes 110 are plated with an electrically conductive material 111, e.g. copper. It can be seen that, at the top of each through hole 110, the opening diameter is larger than the further diameter of the through holes, which is not the opening diameter (the hole diameter at the main surface of the layer stack 101 is enlarged).

A first curable dielectric element 120, being in this example a pre-cured prepreg (a glass fiber enforced epoxy resin, e.g. FR4) that is formed as a sheet, is arranged on top of the openings 110. A part 121 of the first curable dielectric element 120 extends partially into the openings 110. This extension is down to a predetermined filling depth. The first curable dielectric element 120 is in a first cure state (for example with a cross-linking state of 30%), wherein the cure state has been pre-determined (and fulfills a predetermined cure state criterion) in order to achieve a controlled flow of curable dielectric material 121 into the openings 110.

In this example, the through holes 110 serve for establishing a press-fit connection to a further component carrier. A protruding element of the further component carrier (not shown) will be pressed into the component carrier openings 110 (in this view from below) up to a specific height. However, during a further lamination step on top of the component carrier 100 layer stack 101, the through holes 110 would be completely filled with insulating material (e.g. resin). Conventional plugin pastes are generally not reliable enough and would fill the through holes 110 too little or too much. However, with the described first curable dielectric element 120, which has a predetermined cure state and hence a controllable flow viscosity, enables a reliable and robust partial filling of the through holes 110.

The component carrier 100 further comprises two second curable (essentially not pre-cured) dielectric elements 130 that are arranged adjacent (side-by-side) with the first curable dielectric element 120, so that there are two respective interface regions 150 in between. The cure state of the first curable dielectric element 120 is more cured than the cure state of the second dielectric element 130, i.e. being more viscos and/or more cross-linked. Besides the difference in the cure state, the first curable dielectric element 120 and the second curable dielectric elements 130 comprise the same material, e.g. a prepreg. The difference in the cure state is also determinable at the interface region 150 as an interface pattern. The second dielectric element 130 is not arranged on top of the openings 110.

**Figures 2a to 2d** show a method of manufacturing a component carrier 100 according to an exemplary embodiment of the invention.

Figure 2a: there is provided a layer stack 101 with an electrically insulating layer structure 102 and electrically conductive layer structures 104. Openings in the form of through holes 110 are formed in the electrically insulating layer structure 102 of the layer stack 101.

Figure 2b: two second curable dielectric elements 130 with a second cure state have been arranged on the top of the layer stack 101. In between the two second curable dielectric elements 130, there is a cut-out region 132. Either the two second curable dielectric elements 130 have been arranged separately adjacent to the cut-out region 132 or there has been arranged one second curable dielectric element 130 and a part of it has been cut-out.

Figure 2c: a first curable dielectric element 120 with a first cure state is arranged on top of the plurality of through holes 110 and in the cut-out region 132 between the two second curable dielectric elements 130, thereby forming two interface regions 150.

Figure 2d: the first curable dielectric element 120 extends partially into the openings 110, wherein extending comprises: flowing material 121 of the first curable dielectric element 120 into the openings 110 in a controlled manner regarding filling depth and the amount of flowing material. This control is enabled by a predetermined first cure state. For example, the cure state of the first curable dielectric element 120 (and the second curable dielectric element 130) is analyzed in advance to determine and adapt/adjust the first cure state to a (predetermined) cure state criterion.

In a further step, a further electrically insulating layer structure 140 is laminated on top of the first curable dielectric element 120 and the second curable dielectric elements 130. The openings 110 are not completely filled by the lamination step due to the first curable dielectric element 120 that partially fills the openings 110 to a specific predetermined depth.

**Figures 3a to 3d** respectively show an interface pattern 155 according to exemplary embodiments of the invention. Different materials can be observed due to the different colour, material structure and composition, also that there may be a cut seen in the glass fiber. Depending on the materials, different (material) analysis method can be applied.

**Figure 4** shows a side view of a component carrier 100 with a component 160 in a cavity 110 according to an illustrative example.

The component carrier 100 comprises a layer stack 101 with a plurality of electrically insulating layer structures 102 and electrically conductive layer structures 104. In the center (in a horizontal direction) of the layer stack 101, there is arranged a cavity 110 in a lower electrically insulating layer structure 102. The electric component 160 is placed in the cavity 110 and is electrically connected to an electrically conductive layer structure at the bottom outer main surface of the component carrier 100. On top of the lower electrically insulating layer structure 102, there are arranged two second curable dielectric element segments 130. These are respectively adjacent to two first curable dielectric element segments 120 that cover the tops of the sidewalls of the cavity 110 and slightly overlap in a region above the cavity 110.

The electric component 160 is not covered by the first curable dielectric elements 120. On the curable dielectric elements 120, 130, there is arranged an upper electrically insulating layer structure 102 with respective conductive layer structures 104. Depending on the desired functionality, the first cure state can be chosen such that a part of the first curable dielectric elements 120 extends into the cavity 110 and partially fills it, thereby arriving at a component carrier that belongs to the invention as claimed. Hereby, the embedded component 160 can be partially encapsulated, for example the region between the cavity sidewalls and the component sidewalls can be filled in a controlled manner. In an illustrative example not belonging to the invention, the first cure state is already very hard and there will be essentially no flow into the cavity 110.

**Figure 5** shows a side view of a component carrier 100 with a component 160 in a cavity 110 according to another illustrative example. This example is very similar to the one shown in Figure 4 with the difference being that the electric component 160 is covered by the first curable dielectric element 120. Further, the top of the sidewall of the cavity 110 is not covered by the first curable dielectric element 120. In this configuration, a part of the first curable dielectric element 120 can flow in a controlled manner into the cavity 110 and (at least partially) fill it, thereby arriving at a component carrier that belongs to the invention as claimed. In a further illustrative example, a part of the first curable dielectric element 120 flows down to cover the tops of the sidewalls of the cavity 110. In another illustrative example, the first cure state is already very hard and there will be essentially no flow into the cavity 110.

**Figure 6** shows a side view of a component carrier 100 with a fluid-filled cavity 110 according to an exemplary embodiment of the invention. This example is very similar to the ones shown in Figures 4 and 5 above. However, there is no electric component arranged in the cavity 110. The first curable dielectric element 120 covers the cavity 110 and also covers the tops of the sidewalls of the cavity 110. Depending on the predetermined first cure state, a part 121 of the first curable dielectric element 120 flows into the cavity 110 and partially fills it, thereby arriving at a component carrier that belongs to the invention as claimed.

For example, the sidewalls of the cavity 110 can be covered with dielectric material. In another illustrative example, the first cure state is already very hard and there will be essentially no flow into the cavity 110.

**Figure 7** shows a side view of two different filling heights in the opening 110 according to an exemplary embodiment of the invention. The left hole 110a is partially filled by a part 121 of the first curable material 120, that extends into the opening 110a, to a filling height of around 20% of the opening (volume). The right hole 110b is filled by another part 121 of the first curable material 120, that extends into the opening 110b to a filling height of around 5% of the opening (volume).

**Figure 8** shows a component carrier arrangement 200 according to an exemplary embodiment of the invention. The component carrier arrangement 200 comprises a component carrier 100, being the component carrier 100 described in the previous examples, and a further component carrier or further component 250. The further component (carrier) 250 comprises protruding elements 210 that are configured to establish a press-fit connection together with the openings 110 of the component carrier 100. For this purpose, the first curable dielectric element 120 extends only partially 121 into the openings 110 to a specific filling height h.

**Figures 9a to 9c** show side views of a specifically shaped part of the first curable dielectric element 120 in the opening 110. For example, due to surface tension, applied pressure and friction at the side walls, a shaped portion can be achieved.

Figure 9a shows a hemispherical shape of a convex main surface 122 of the part 121 that extends into the opening 110.

Figure 9b shows a further example of a part 121 with a deeper filling height. It is indicated that an angle a can be determined between the opening sidewall and the curved shape.

Figure 9c shows a side view of a part 121 of the first curable dielectric element 120 that extends into the opening 110 and comprises no glass-fibers. In contrast, the part that does not extend comprises a glass fiber 123 which is wave-like formed at the opening main surface 112.

### Reference signs

- 100: Component carrier
- 101: Layer stack
- 102: Electrically insulating layer structure
- 104: Electrically conductive layer structure
- 110: Opening, through hole, cavity
- 111: Electrically conductive material
- 112: Opening main surface
- 113: Backdrill-opening
- 120: First curable dielectric element
- 121: Extending part of first curable dielectric element
- 122: Extending part shaped main surface
- 123: Glass fiber
- 130: Second curable dielectric element
- 132: Cut-out region
- 140: Further electrically insulating layer structure
- 150: Interface region
- 155: Interface pattern
- 160: Electronic component
- 200: Component carrier arrangement
- 210: Protruding element
- 250: Further component carrier, further component

## Claims

1. A component carrier (100) comprising:
a layer stack (101) with at least one electrically insulating layer structure (102) and/or at least one electrically conductive layer structure (104);
at least one opening (110) in the layer stack (101);
a first curable dielectric element (120) arranged at least partially on the opening (110); and
a second curable dielectric element (130) arranged adjacent side-by-side to the first curable dielectric element (120), so that there is an interface region (150) in between;
wherein a part (121) of the first curable dielectric element (120) extends partially into the opening (110),
wherein the cure state of the first curable dielectric element (120) is more cured than the cure state of the second curable dielectric element (130) , and
wherein this difference in the cure state is determinable at the interface region (150) as an interface pattern (155).

2. The component carrier (100) according to claim 1,
wherein the interface pattern (155) comprises at least one of the group which consists of at least one cut fiber, in particular a cut glass fiber, an alignment shift, a smearing, a colour shift, a tapering.

3. The component carrier (100) according to any one of the preceding claims,
wherein the part (121) of the first curable dielectric element (120) extends into the opening (110) to a specific filling height, in particular
wherein the filling height corresponds to 5% or more of the opening volume, and/or wherein the filling height corresponds to 50% or less of the opening volume.

4. The component carrier (100) according to any one of the preceding claims, wherein the part (121) of the first curable dielectric element (120) that extends into the opening (110) comprises a shaped main surface (122), in particular a hemisphere-like shape, more in particular a concave or convex shape.

5. The component carrier (100) according to any one of the preceding claims, wherein the part (121) of the first curable dielectric element (120) that extends into the opening (110) essentially comprises no glass-fibers,
in particular, wherein a glass fiber (123) of the first curable dielectric element (120) forms a wave-like structure at the opening main surface (112).

6. The component carrier (100) according to any one of the preceding claims, wherein the opening (110) comprises at least one of the group which consists of a blind hole, a through hole, a cavity, a trench, a recess between traces.

7. The component carrier (100) according to any one of the preceding claims, wherein sidewalls of the opening (110) are at least partially covered by an electrically conductive material (111).

8. The component carrier (100) according to any one of the preceding claims, wherein a diameter of the opening (110, 113) exposed at a layer stack (101) main surface, in particular an opening main surface (112), is larger than a diameter of the opening (110) which is not exposed at the layer stack (101) main surface,
in particular wherein the diameter at the opening main surface (112) is a backdrill-opening (113).

9. The component carrier (100) according to any one of the preceding claims, wherein the opening (110) is a fluid-filled, in particular gas-filled, more in particular air filled, cavity embedded in the layer stack (101).

10. A component carrier arrangement (200), comprising:
a component carrier (100) according to any one of the preceding claims; and
a further component carrier (250) or a further component comprising a protruding element (210);
wherein the further component carrier (250) or the further component is stacked on the component carrier (100); and
wherein the protruding element (210) is at least partially inserted into the opening (110) in order to connect the component carrier (100) with the further component carrier (250) or the further component.

11. A method of manufacturing a component carrier (100), the method comprising:
providing a layer stack (101) with at least one electrically insulating layer structure (102) and/or at least one electrically conductive layer structure (104);
forming at least one opening (110) in the layer stack (101);
arranging a first curable dielectric element (120) with a first cure state at least partially on the opening (110);
arranging a second curable dielectric element (130) with a second cure state adjacent side-by-side to the first curable dielectric element (120), thereby forming an interface region (150) in between, wherein arranging comprises:
arranging the second curable dielectric element (130) to provide a cut-out region (132) on the opening (110), and
arranging the first curable dielectric element (120) in the cut-out region (132);
wherein the first cure state is more cured than the second cure state.

12. The method according to claim 11, the method further comprising:
extending a part (121) of the first curable dielectric element (120) into the opening (110),
in particular wherein extending comprises:
flowing material (121) of the first curable dielectric element (120) into the opening (110) in a controlled manner, in particular with respect to at least one of the group which consists of filling depth, amount of flow material, speed of flow material, shape of the flow material.

13. The method according to claim 11 or 12, further comprising:
predefining a cure state criterion, in particular including at least one of viscosity and filling height; and
tuning the first curable dielectric element (120) so that the first cure state fulfills the cure state criterion;

14. The method according to one of the claims 11 to 13, further comprising:
laminating a further electrically insulating layer structure (140) and/or a further electrically conductive layer structure on the first curable dielectric element (120),
in particular wherein the first cure state and the second cure state are different after lamination or wherein the first cure state and the second cure state are the same after lamination; and/or
back-drilling the opening (110) at an opening main surface (112) that is exposed to a layer stack (101) main surface.

15. Using the method according to any one of claims 11 to 14 for interconnecting a further component carrier (250) or a further component at the opening (110).

## Patentansprüche

1. Ein Komponententräger (100), aufweisend:
einen Schichtstapel (101) mit mindestens einer elektrisch isolierenden Schichtstruktur (102) und/oder mindestens einer elektrisch leitfähigen Schichtstruktur (104);
mindestens eine Öffnung (110) in dem Schichtstapel (101);
ein erstes aushärtbares dielektrisches Element (120), das zumindest teilweise auf der Öffnung (110) angeordnet ist; und
ein zweites aushärtbares dielektrisches Element (130), das benachbart neben dem ersten aushärtbaren dielektrischen Element (120) angeordnet ist, so dass sich dazwischen ein Schnittstellenbereich (150) befindet;
wobei sich ein Teil (121) des ersten aushärtbaren dielektrischen Elements (120) teilweise in die Öffnung (110) erstreckt,
wobei der Aushärtungszustand des ersten aushärtbaren dielektrischen Elements (120) stärker ausgehärtet ist als der Aushärtungszustand des zweiten aushärtbaren dielektrischen Elements (130), und
wobei dieser Unterschied im Aushärtungszustand an dem Schnittstellenbereich (150) als ein Schnittstellenmuster (155) bestimmbar ist.

2. Der Komponententräger (100) gemäß Anspruch 1,
wobei das Schnittstellenmuster (155) zumindest eines aus der Gruppe aufweist, die aus zumindest einer geschnittenen Faser, insbesondere einer geschnittenen Glasfaser, einer Ausrichtungsverschiebung, einer Verschmierung, einer Farbverschiebung, einer Verjüngung besteht.

3. Der Komponententräger (100) gemäß einem der vorhergehenden Ansprüche,
wobei sich der Teil (121) des ersten aushärtbaren dielektrischen Elements (120) bis zu einer bestimmten Füllhöhe in die Öffnung (110) erstreckt, insbesondere wobei die Füllhöhe 5% oder mehr des Öffnungsvolumens entspricht, und/oder wobei die Füllhöhe 50% oder weniger des Öffnungsvolumens entspricht.

4. Der Komponententräger (100) gemäß einem der vorhergehenden Ansprüche,
wobei der Teil (121) des ersten aushärtbaren dielektrischen Elements (120), der sich in die Öffnung (110) erstreckt, eine geformte Hauptfläche (122), insbesondere eine halbkugelartige Form, insbesondere eine konkave oder konvexe Form, aufweist.

5. Der Komponententräger (100) gemäß einem der vorhergehenden Ansprüche,
wobei der Teil (121) des ersten aushärtbaren dielektrischen Elements (120), der sich in die Öffnung (110) erstreckt, im Wesentlichen keine Glasfasern aufweist, insbesondere wobei eine Glasfaser (123) des ersten aushärtbaren dielektrischen Elements (120) eine wellenartige Struktur an der Öffnungshauptfläche (112) bildet.

6. Der Komponententräger (100) gemäß einem der vorhergehenden Ansprüche,
wobei die Öffnung (110) zumindest eines aus der Gruppe aufweist, die aus einem Sackloch, einem Durchgangsloch, einer Kavität, einem Graben, einer Aussparung zwischen Leiterbahnen besteht.

7. Der Komponententräger (100) gemäß einem der vorhergehenden Ansprüche,
wobei Seitenwände der Öffnung (110) zumindest teilweise mit einem elektrisch leitfähigen Material (111) bedeckt sind.

8. Der Komponententräger (100) gemäß einem der vorhergehenden Ansprüche,
wobei ein Durchmesser der Öffnung (110, 113), die an einer Schichtstapel (101)-Hauptoberfläche, insbesondere einer Öffnungshauptoberfläche (112), freiliegt, größer ist als ein Durchmesser der Öffnung (110), die nicht an der Schichtstapel (101)-Hauptoberfläche freiliegt,
insbesondere wobei der Durchmesser an der Öffnungshauptoberfläche (112) eine Hinterbohrungsöffnung (113) ist.

9. Der Komponententräger (100) gemäß einem der vorhergehenden Ansprüche,
wobei die Öffnung (110) eine fluidgefüllte, insbesondere gasgefüllte, weiter insbesondere luftgefüllte, Kavität ist, die in dem Schichtstapel (101) eingebettet ist.

10. Eine Komponententrägeranordnung (200), aufweisend:
einen Komponententräger (100) gemäß einem der vorhergehenden Ansprüche; und
einen weiteren Komponententräger (250) oder eine weitere Komponente, die ein vorstehendes Element (210) aufweist;
wobei der weitere Komponententräger (250) oder die weitere Komponente auf dem Komponententräger (100) gestapelt ist; und
wobei das vorstehende Element (210) zumindest teilweise in die Öffnung (110) eingesetzt ist, um den Komponententräger (100) mit dem weiteren Komponententräger (250) oder der weiteren Komponente zu verbinden.

11. Ein Verfahren zum Herstellen eines Komponententrägers (100), das Verfahren aufweisend:
Bereitstellen eines Schichtstapels (101) mit mindestens einer elektrisch isolierenden Schichtstruktur (102) und/oder mindestens einer elektrisch leitfähigen Schichtstruktur (104);
Bilden mindestens einer Öffnung (110) in dem Schichtstapel (101);
Anordnen eines ersten aushärtbaren dielektrischen Elements (120) mit einem ersten Aushärtungszustand zumindest teilweise auf der Öffnung (110);
Anordnen eines zweiten aushärtbaren dielektrischen Elements (130) mit einem zweiten Aushärtungszustand benachbart neben dem ersten aushärtbaren dielektrischen Element (120), dadurch Bilden eines Schnittstellenbereichs (150) dazwischen, wobei das Anordnen aufweist:
Anordnen des zweiten aushärtbaren dielektrischen Elements (130), um einen ausgeschnittenen Bereich (132) auf der Öffnung (110) bereitzustellen, und
Anordnen des ersten aushärtbaren dielektrischen Elements (120) in dem ausgeschnittenen Bereich (132);
wobei der erste Aushärtungszustand stärker ausgehärtet ist als der zweite Aushärtungszustand.

12. Das Verfahren gemäß Anspruch 11, das Verfahren ferner aufweisend:
Erstrecken eines Teils (121) des ersten aushärtbaren dielektrischen Elements (120) in die Öffnung (110),
insbesondere wobei das Erstrecken aufweist:
Fließen von Material (121) des ersten aushärtbaren dielektrischen Elements (120) in die Öffnung (110) auf eine gesteuerte Weise, insbesondere in Bezug auf zumindest eines aus der Gruppe, die aus Fülltiefe, Menge an Fließmaterial, Geschwindigkeit des Fließmaterials, Form des Fließmaterials besteht.

13. Das Verfahren gemäß Anspruch 11 oder 12, ferner aufweisend:
Vordefinieren eines Aushärtungszustandskriteriums, das insbesondere zumindest eines aus Viskosität und Füllhöhe beinhaltet; und
Einstellen des ersten aushärtbaren dielektrischen Elements (120), so dass der erste Aushärtungszustand das Aushärtungszustandskriterium erfüllt.

14. Das Verfahren gemäß einem der Ansprüche 11 bis 13, ferner aufweisend:
Laminieren einer weiteren elektrisch isolierenden Schichtstruktur (140) und/oder einer weiteren elektrisch leitfähigen Schichtstruktur auf das erste aushärtbare dielektrische Element (120),
insbesondere wobei der erste Aushärtungszustand und der zweite Aushärtungszustand nach dem Laminieren unterschiedlich sind oder wobei der erste Aushärtungszustand und der zweite Aushärtungszustand nach dem Laminieren gleich sind; und/oder
Hinterbohren der Öffnung (110) an einer Öffnungshauptoberfläche (112), die zu einer Schichtstapel (101)-Hauptoberfläche freiliegt.

15. Verwenden des Verfahrens gemäß einem der Ansprüche 11 bis 14 zum Verbinden eines weiteren Komponententrägers (250) oder einer weiteren Komponente an der Öffnung (110).

## Revendications

1. Support de composant (100), comprenant
un empilement de couches (101) avec au moins une structure de couche électriquement isolante (102) et/ou au moins une structure de couche électroconductrice (104) ;
au moins une ouverture (110) dans l'empilement de couches (101) ;
un premier élément diélectrique durcissable (120) agencé au moins partiellement sur l'ouverture (110) ; et
un second élément diélectrique durcissable (130) agencé adjacent côte à côte par rapport au premier élément diélectrique durcissable (120), de sorte qu'il y ait une région d'interface (150) entre eux ;
dans lequel une partie (121) du premier élément diélectrique durcissable (120) s'étend partiellement dans l'ouverture (110),
dans lequel l'état de durcissement du premier élément diélectrique durcissable (120) est plus durci que l'état de durcissement du second élément diélectrique durcissable (130), et
dans lequel cette différence dans l'état de durcissement peut être déterminée au niveau de la région d'interface (150) en tant que motif d'interface (155).

2. Support de composant (100) selon la revendication 1,
dans lequel le motif d'interface (155) comprend au moins un élément du groupe qui consiste en au moins une fibre coupée, en particulier une fibre de verre coupée, un décalage d'alignement, un maculage, un décalage de couleur, un effilement.

3. Support de composant (100) selon l'une quelconque des revendications précédentes, dans lequel la partie (121) du premier élément diélectrique durcissable (120) s'étend dans l'ouverture (110) jusqu'à une hauteur de remplissage spécifique, en particulier dans lequel la hauteur de remplissage correspond à 5 % ou plus du volume d'ouverture, et/ou dans lequel la hauteur de remplissage correspond à 50 % ou moins du volume d'ouverture.

4. Support de composant (100) selon l'une quelconque des revendications précédentes, dans lequel la partie (121) du premier élément diélectrique durcissable (120) qui s'étend dans l'ouverture (110) comprend une surface principale mise en forme (122), en particulier une forme de type hémisphère, plus particulièrement une forme concave ou convexe.

5. Support de composant (100) selon l'une quelconque des revendications précédentes, dans lequel la partie (121) du premier élément diélectrique durcissable (120) qui s'étend dans l'ouverture (110) ne comprend essentiellement pas de fibres de verre, en particulier, dans lequel une fibre de verre (123) du premier élément diélectrique durcissable (120) forme une structure analogue à une onde au niveau de la surface principale d'ouverture (112).

6. Support de composant (100) selon l'une quelconque des revendications précédentes, dans lequel l'ouverture (110) comprend au moins un élément du groupe qui consiste en un trou borgne, un trou traversant, une cavité, une tranchée, un évidement entre des traces.

7. Support de composant (100) selon l'une quelconque des revendications précédentes, dans lequel les parois latérales de l'ouverture (110) sont au moins partiellement recouvertes d'un matériau électroconducteur (111).

8. Support de composant (100) selon l'une quelconque des revendications précédentes, dans lequel un diamètre de l'ouverture (110, 113) exposée au niveau d'une surface principale d'empilement de couches (101), en particulier une surface principale d'ouverture (112), est plus grand qu'un diamètre de l'ouverture (110) qui n'est pas exposée au niveau de la surface principale d'empilement de couches (101),
en particulier dans lequel le diamètre au niveau de la surface principale d'ouverture (112) est une ouverture de rétroperçage (113).

9. Support de composant (100) selon l'une quelconque des revendications précédentes, dans lequel l'ouverture (110) est une cavité remplie de fluide, en particulier remplie de gaz, plus particulièrement remplie d'air, incorporée dans l'empilement de couches (101).

10. Agencement de supports de composant (200), comprenant :
un support de composant (100) selon l'une quelconque des revendications précédentes ; et
un support de composant supplémentaire (250) ou un composant supplémentaire comprenant un élément en saillie (210) ;
dans lequel le support de composant supplémentaire (250) ou le composant supplémentaire est empilé sur le support de composant (100) ; et
dans lequel l'élément en saillie (210) est au moins partiellement inséré dans l'ouverture (110) afin de connecter le support de composant (100) avec le support de composant supplémentaire (250) ou le composant supplémentaire.

11. Procédé de fabrication d'un support de composant (100), le procédé comprenant les étapes consistant à :
fournir un empilement de couches (101) avec au moins une structure de couche électriquement isolante (102) et/ou au moins une structure de couche électroconductrice (104) ;
former au moins une ouverture (110) dans l'empilement de couches (101) ;
agencer un premier élément diélectrique durcissable (120) avec un premier état de durcissement au moins partiellement sur l'ouverture (110) ;
agencer un second élément diélectrique durcissable (130) avec un second état de durcissement adjacent côte à côte par rapport au premier élément diélectrique durcissable (120), en formant ainsi une région d'interface (150) entre eux, dans lequel l'agencement comprend les étapes consistant à :
agencer le second élément diélectrique durcissable (130) pour fournir une région découpée (132) sur l'ouverture (110), et
agencer le premier élément diélectrique durcissable (120) dans la région découpée (132) ;
dans lequel le premier état de durcissement est plus durci que le second état de durcissement.

12. Procédé selon la revendication 11, le procédé comprend en outre l'étape consistant à :
étendre une partie (121) du premier élément diélectrique durcissable (120) jusque dans l'ouverture (110),
en particulier dans lequel l'extension comprend l'étape consistant à :
amener le matériau (121) du premier élément diélectrique durcissable (120) à s'écouler dans l'ouverture (110) d'une manière commandée, en particulier par rapport à au moins un élément du groupe qui consiste en la profondeur de remplissage, la quantité de matériau d'écoulement, la vitesse du matériau d'écoulement, la forme du matériau d'écoulement.

13. Procédé selon la revendication 11 ou 12, comprenant en outre les étapes consistant à :
prédéfinir un critère d'état de durcissement, incluant en particulier au moins un parmi la viscosité et la hauteur de remplissage ; et
régler le premier élément diélectrique durcissable (120) de sorte que le premier état de durcissement remplisse le critère d'état de durcissement.

14. Procédé selon l'une quelconque des revendications 11 à 13, comprenant en outre les étapes consistant à :
stratifier une structure de couche électriquement isolante supplémentaire (140) et/ou une structure de couche électroconductrice supplémentaire sur le premier élément diélectrique durcissable (120),
en particulier dans lequel le premier état de durcissement et le second état de durcissement sont différents après la stratification ou dans lequel le premier état de durcissement et le second état de durcissement sont les mêmes après la stratification ; et/ou
rétropercer l'ouverture (110) au niveau d'une surface principale d'ouverture (112) qui est exposée à une surface principale d'empilement de couches (101).

15. Utilisation du procédé selon l'une quelconque des revendications 11 à 14 pour interconnecter un support de composant supplémentaire (250) ou un composant supplémentaire au niveau de l'ouverture (110).
